(19) Europäisches Patentamt / European Patent Office / Office européen des brevets

(11) **EP 2 001 074 B1**

(12) **FASCICULE DE BREVET EUROPEEN**

(45) Date de publication et mention
de la délivrance du brevet:
**01.09.2010 Bulletin 2010/35**

(51) Int Cl.:
*H01M 10/44* *(2006.01)* *H01M 10/48* *(2006.01)*
*G01R 31/36* *(2006.01)*

(21) Numéro de dépôt: **08305229.0**

(22) Date de dépôt: **03.06.2008**

(54) **Système et procédé de détermination de la perte de capacité et de l'énergie d'une batterie**

System und Verfahren zur Bestimmung der Leistungsfähigkeit und der Energie einer Batterie

System and method to determine the loss in capacity and energy of a battery determining the output capacity of a battery

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **07.06.2007 FR 0755559**

(43) Date de publication de la demande:
**10.12.2008 Bulletin 2008/50**

(73) Titulaire: **Peugeot Citroën Automobiles SA**
**78140 Vélizy-Villacoublay (FR)**

(72) Inventeur: **Porcellato, M. Denis**
**78450 Chavenay (FR)**

(56) Documents cités:
**EP-A- 0 560 468      EP-A- 1 505 402**
**EP-A- 1 505 403      EP-A- 1 598 913**
**EP-A- 1 707 974      EP-A- 1 873 542**
**WO-A-2006/058970    FR-A- 2 826 457**

## Description

La présente invention concerne un système de détermination de la perte de capacité d'une batterie depuis la mise en service de ladite batterie.

Plus particulièrement, l'invention se rapporte à la détermination de l'énergie disponible à chaque instant, tout au long de la durée d'utilisation de la batterie, par l'estimation de la perte de capacité de la batterie.

L'invention concerne plus particulièrement les batteries de traction utilisées dans les véhicules notamment hybrides pour lesquels il est indispensable de mettre en oeuvre une gestion intelligente de l'énergie électrique.

L'évolution de l'énergie d'une batterie est directement liée à sa perte de capacité au cours du temps. Elle dépend ainsi directement du degré de vieillissement de la batterie. Ce dernier est propre à chaque utilisation du véhicule c'est-à-dire à l'historique de chaque batterie montée à bord du véhicule.

Classiquement, la loi de variation du degré de vieillissement de la batterie est estimée à partir d'essais de vieillissement effectués sur un banc selon un profil de mission bien particulier.

EP 1707974 décrit un système et un procédé de détermination de la capacité restante d'une batterie.

Par conséquent, ces essais ne permettent généralement pas de déterminer le degré de vieillissement de la batterie précisément pour chaque véhicule, puisque chaque batterie a son propre historique en termes de sollicitations en courant et en température.

On conçoit que ceci représente un inconvénient pour une détermination précise de la perte de capacité de la batterie et de son énergie disponible à tout moment.

Le but de l'invention est de résoudre ce problème.

Plus particulièrement, l'invention vise à déterminer la perte de capacité d'une batterie, à tout moment, en prenant en compte le vieillissement de la batterie et son propre historique.

L'invention vise également à fournir une solution destinée à être embarquée sur un véhicule et peu coûteuse afin d'estimer l'énergie disponible de la batterie à tout instant.

A cet effet, l'invention a pour objet un système de détermination de la perte de capacité d'une batterie depuis la mise en service de ladite batterie, caractérisé en ce qu'il comporte :

- des moyens de mesure de la température de la batterie ;
- des moyens de mesure du courant traversant la batterie ;
- des moyens d'intégration du courant traversant la batterie depuis le dernier recalage de l'état de charge de la batterie ;
- des moyens de calcul d'un état de charge de la batterie à la température mesurée à partir de l'intégration du courant ;
- des moyens de mémorisation de courbes représentant la tension de repos après un temps de la batterie avant sa mise en service en fonction de son état de charge à différentes températures ;
- des moyens de mesure de la tension de repos après un temps de la batterie à la température mesurée et à l'état de charge calculé ;
- des moyens de calcul d'un état de charge réel à partir de la tension de repos après un temps mesurée et de la courbe représentant la tension de repos après un temps de la batterie avant sa mise en service en fonction de son état de charge à la température mesurée ; et
- des moyens de comparaison de cet état de charge réel à l'état de charge calculé pour déterminer la perte de capacité de la batterie.

L'invention a également pour objet un procédé de détermination de la perte de capacité d'une batterie depuis la mise en service de ladite batterie, caractérisé en ce qu'il comporte :

- une étape préalable de mémorisation de courbes représentant la tension de repos après un temps de la batterie avant sa mise en service en fonction de son état de charge à différentes températures ;
- une étape de mesure de la température de la batterie ;
- une étape de mesure du courant traversant la batterie ;
- une étape d'intégration du courant traversant la batterie depuis le dernier recalage de l'état de charge de la batterie ;
- une étape de calcul d'un état de charge de la batterie à la température mesurée à partir de l'intégration du courant ;
- une étape de mesure de la tension de repos après un temps de la batterie à la température mesurée et à l'état de charge calculé ;
- une étape de calcul d'un état de charge réel à partir de la tension de repos après un temps mesurée et de la courbe représentant la tension de repos après un temps de la batterie avant sa mise en service en fonction de son état de charge à la température mesurée ; et
- une étape de comparaison de cet état de charge réel à l'état de charge calculé pour déterminer la perte de capacité de la batterie.

Suivant des modes particuliers de réalisation, le procédé est caractérisé en ce que :

- la batterie est une batterie électrochimique,
- la batterie est choisie parmi le groupe comportant des batteries de type Li-ion, NiMH, Ni-Zn, Plomb acide.

On va maintenant décrire des modes de réalisation de l'invention de façon plus précise mais non limitative en regard des dessins annexés, sur lesquels :

- la figure 1 est un schéma synoptique illustrant la structure d'un système de détermination selon l'invention ;
- la figure 2 est constituée de deux courbes illustrant le principe de la détermination mise en oeuvre selon l'invention ; et
- la figure 3 est un organigramme illustrant le fonctionnement du système de détermination selon l'invention.

Le système selon l'invention détermine la perte de capacité d'une batterie grâce à une mesure de la tension de repos, mesurée à un temps t après le début de la phase de repos durant laquelle l'intensité du courant qui traverse la batterie est nulle. La tension de repos après un temps t est mesurée à un certain état de charge de la batterie.

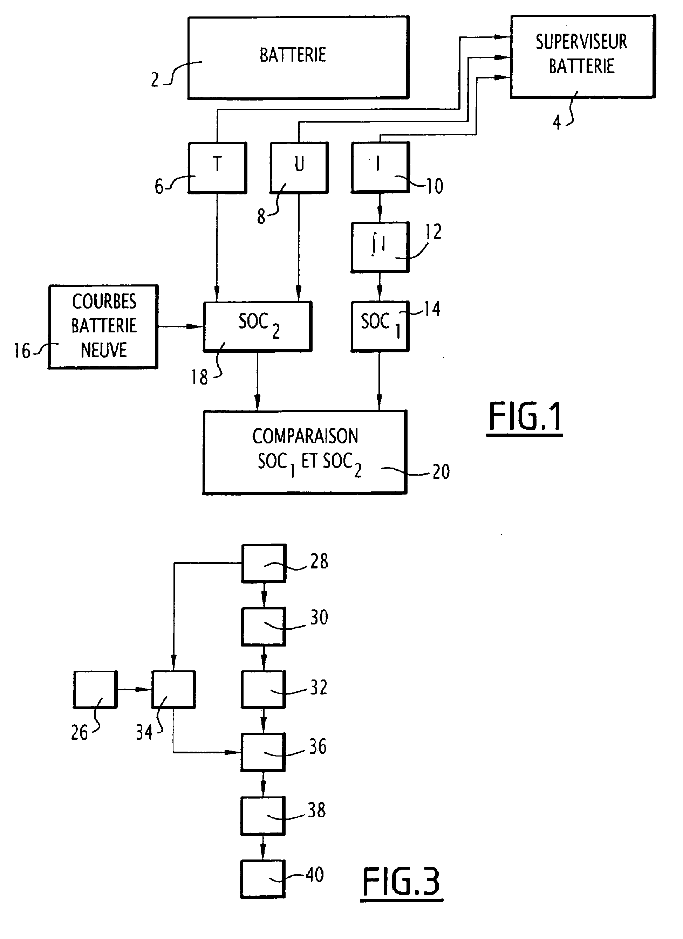

On a illustré sur la figure 1 un schéma synoptique d'un tel système qui représente un mode de réalisation du diagnostic de la batterie pour déterminer sa perte de capacité selon l'invention.

Une telle batterie est désignée par la référence générale 2. La gestion de cette batterie est assurée par un superviseur de la batterie désigné par la référence générale 4.

La batterie 2 est associée à des moyens de mesure de la température de la batterie 2 désignés par la référence générale 6, à des moyens de mesure de la tension de repos après un temps t de la batterie 2 désignés par la référence 8 et à des moyens de mesure du courant traversant la batterie 2 désignés par la référence 10.

La sortie des moyens de mesure de courant 10 est reliée à des moyens d'intégration 12 du courant traversant la batterie 2 depuis le dernier recalage de son état de charge. La sortie de ces moyens d'intégration 12 est reliée à des moyens de calcul d'un état de charge noté $SOC_1$ de la batterie 2 et désignés par la référence générale 14.

Des moyens de mémorisation 16 de courbes représentant la tension de repos après un temps t de la batterie 2 avant sa mise en service en fonction de son état de charge à différentes températures sont également prévus.

Les sorties des moyens de mesure de température 6 et de la tension de repos après un temps t 8 ainsi que des moyens de mémorisation 16 sont reliées à des moyens de calcul d'un état de charge réel noté $SOC_2$ de la batterie 2 et désignés par la référence 18.

Les moyens de calcul de l'état de charge $SOC_1$ 14 et de l'état de charge $SOC_2$ 18 sont reliés à des moyens de comparaison 20 des états de charge $SOC_1$ et $SOC_2$.

Il convient également de noter que les moyens de mesure de température 6, de la tension de repos après un temps t 8 et de courant 10 sont reliés au superviseur 4 de la batterie 2 pour lui permettre de gérer l'état de charge et la thermique de la batterie 2 notamment en veillant à ce que la température et l'état de charge restent compris dans les limites permises par le constructeur de la batterie 2.

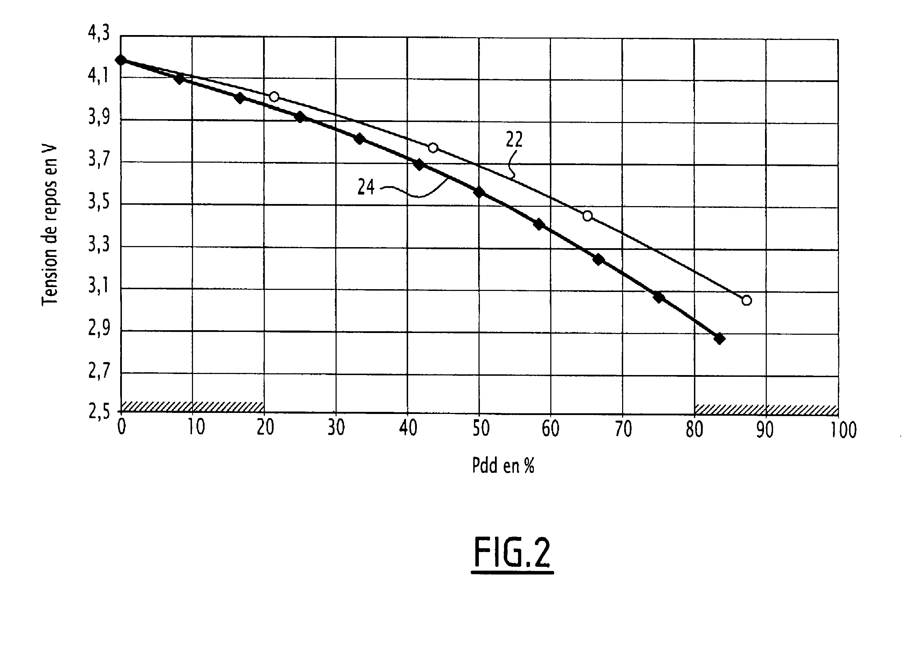

La figure 2 est une superposition de deux courbes 22 et 24 correspondant respectivement à une batterie neuve et à une batterie usagée par exemple de type lithium qui permet d'illustrer le principe de détermination de la perte de capacité, selon l'invention.

Les courbes 22 et 24 représentent la tension de repos après un temps t exprimée en volts respectivement de la batterie neuve et usagée en fonction de son état de charge, ou plus précisément en fonction de sa profondeur de décharge exprimée en %. La profondeur de décharge d'une batterie est notée Pdd. Elle est relié à l'état de charge de la batterie noté SOC selon la relation : Pdd = (100-SOC) %.

Il convient de noter, que dans la suite de la description, les notions d'état de charge et de profondeur de décharge seront utilisées pour définir un même concept étant donné la relation directe qui les lie.

La courbe 22 correspond à une température de 20° et elle est obtenue à partir des moyens de mémorisation 16. Elle représente la tension de repos après un temps t en fonction de l'état de charge de la batterie 2 avant sa mise en service.

La courbe 24 correspond également à une température de 20° et elle est obtenue à l'aide des moyens de calcul 14 de l'état de charge $SOC_1$ qui utilisent la mesure de courant traversant la batterie 2 depuis son dernier recalage.

Plus précisément, l'état de charge $SOC_1$ à l'instant t est calculé par les moyens 14 selon la relation :

$$SOC_1(t) = (SOC_0 - (\int I \,/\, C_{nom} \, dt) * 100)$$

où $SOC_0$ est l'état de charge connu à l'instant initial t = 0, instant auquel s'est opéré le recalage, $C_{nom}$ est la capacité nominale de la batterie fournie par le constructeur et $\int I$ est la quantité d'électricité qui a traversé la batterie pendant la durée t et mesurée par les moyens 12.

Il convient de noter que l'état de charge $SOC_1$ calculé de cette manière ne prend pas en compte le vieillissement de la batterie et n'est donc pas son état de charge réel.

La courbe 24 représente donc, à une température donnée mesurée par les moyens 6, la tension de repos après un temps t mesurée par les moyens 8 en fonction de la profondeur de décharge correspondant à $SOC_1(t)$.

Il convient de noter que les zones hachurées sur l'axe Pdd dans le diagramme de la figure 2 correspondent à des zones de profondeur de décharge non parcourues pour les batteries utilisées pour la traction dans des véhicules hybrides.

Ainsi, de telles batteries sont utilisées impérativement à des états de charge généralement compris entre 20 et 80% afin d'éviter leur dégradation prématurée mais aussi afin de disposer des puissances en charge et décharge requises.

Le principe de l'invention est expliqué à partir d'un exemple utilisant les courbes 22 et 24.

Ainsi, à un état de charge autorisé $SOC_1$ de 30% de la batterie 2 usagée, soit une profondeur de décharge de 70%, la mesure de la tension de repos après un temps t de la batterie 2 à l'aide des moyens 6 à cet état de charge de 30% donne une valeur de force électromotrice égale à 3,18 V.

Le principe de l'invention est lié au fait, vérifié expérimentalement, que la tension de repos après un temps t ne varie pas en fonction de l'état de charge réel de la batterie 2, c'est-à-dire de l'état de charge prenant en compte le vieillissement de la batterie.

Par conséquent, à une même température, la courbe 22 représentant la tension de repos après un temps t en fonction de l'état de charge de la batterie avant sa mise en service est superposée à toute courbe représentant la tension de repos après un temps t en fonction de l'état de charge réel de la batterie à tout moment de la vie de la batterie ; c'est-à-dire quel que soit son vieillissement et sa capacité.

En se reportant à la courbe 22, la valeur de la tension de repos après un temps t de 3,18 V correspond à une profondeur de décharge de 80% soit un état de charge de 20% de la batterie avant sa mise en service. Ainsi, en raison du fait exprimé ci-dessus, l'état de charge réel de la batterie 2 usagée, prenant en compte le vieillissement de la batterie 2, est de 20% et non pas de 30% qui est la valeur calculée à l'aide de la mesure de courant et ne prenant pas en compte le vieillissement de la batterie 2.

Le passage de 70% à 80% de la profondeur de décharge de la batterie 2 représente une augmentation

de ( $\dfrac{80-70}{80}$ )% soit 12,5 % de la profondeur de décharge. Cette valeur de 12,5% représente la perte de capacité de la batterie 2 depuis sa mise en service.

La structure du système selon l'invention ainsi que le principe de ce système pour déterminer la perte de capacité d'une batterie grâce à une mesure de la tension de repos après un temps t ayant été décrits, le fonctionnement de ce système est détaillé dans la suite de la description en référence à la figure 3.

A une étape préalable 26, des courbes représentant la tension de repos après un temps t de la batterie avant sa mise en service en fonction de son état de charge à différentes températures sont mémorisées dans les moyens de mémorisation 16.

A l'étape 28, la température, la tension de repos après un temps t et le courant de la batterie 2 sont mesurés à l'aide des moyens 6, 8 et 10 respectivement.

En 30, les moyens d'intégration 12 intègrent le courant traversant la batterie 2 depuis le dernier recalage de l'état de charge en utilisant la mesure du courant effectuée à l'étape 28 par les moyens de mesure de courant 28.

En 32, les moyens de calcul de l'état de charge $SOC_1$ de la batterie 2 à la température mesurée en 28 calculent l'état de charge $SOC_1$ à partir de l'intégration de courant effectuée à l'étape 30.

Par ailleurs, l'état de charge réel $SOC_2$ de la batterie 2 est calculé en 34 à partir de la mesure de la tension de repos après un temps t de la batterie 2 à l'étape 28 et de la courbe mémorisée en 26 représentant la tension de repos après un temps t de la batterie 2 en fonction de son état de charge avant sa mise en service à la température mesurée en 28.

A l'étape 36, les états de charge $SOC_1$ et $SOC_2$ sont comparés par les moyens de comparaison 20 afin de déterminer en 38 la perte de capacité de la batterie 2.

Selon un mode de réalisation particulier de l'invention, l'énergie disponible dans la batterie 2 est déterminée en 40 à partir de la perte de capacité de la batterie 2 déterminée en 38.

Ainsi, le système selon l'invention permet à partir d'une mesure de la tension de repos après un temps t aux bornes de la batterie de déterminer la perte de capacité de la batterie et son énergie disponible.

Ce système, en plus de prendre en compte le vieillissement de la batterie, présente l'intérêt d'être peu coûteux et simple à mettre en oeuvre sur un véhicule car il utilise des composants qui sont les capteurs de tension, de courant et de température déjà existants.

Un tel système peut être embarqué ou non, ce qui permet d'avoir des mesures en mode roulage ou en mode parking pour un diagnostic de l'énergie disponible dans la batterie.

Bien entendu, d'autres modes de réalisation encore peuvent être envisagés.

## Revendications

1.  Système de détermination de la perte de capacité d'une batterie (2) depuis la mise en service de ladite batterie (2), **caractérisé en ce qu'**il comporte :

    - des moyens (6) de mesure de la température de la batterie ;
    - des moyens (10) de mesure du courant traversant la batterie (2) ;
    - des moyens d'intégration (12) du courant traversant la batterie (2) depuis le dernier recalage de l'état de charge de la batterie (2) ;
    - des moyens de calcul (14) d'un état de charge ($SOC_1$) de la batterie (2) à la température mesurée à partir de l'intégration du courant ;

- des moyens de mémorisation (16) de courbes (22) représentant la tension de repos après un temps (t) de la batterie (2) avant sa mise en service en fonction de son état de charge à différentes températures ;
- des moyens de mesure (8) de la tension de repos après un temps (t) de la batterie à la température mesurée et à l'état de charge calculé ($SOC_1$) ;
- des moyens de calcul (18) d'un état de charge réel ($SOC_2$) à partir de la tension de repos après un temps (t) mesurée et de la courbe (22) représentant la tension de repos après un temps (t) de la batterie (2) avant sa mise en service en fonction de son état de charge à la température mesurée ; et
- des moyens de comparaison (20) de cet état de charge réel ($SOC_2$) à l'état de charge calculé ($SOC_1$) pour déterminer la perte de capacité de la batterie.

**2.** Procédé de détermination de la perte de capacité d'une batterie (2) depuis la mise en service de ladite batterie (2), **caractérisé en ce qu'**il comporte :

- une étape préalable (26) de mémorisation de courbes (22) représentant la tension de repos après un temps (t) de la batterie (2) avant sa mise en service en fonction de son état de charge à différentes températures ;
- une étape (28) de mesure de la température de la batterie (2) ;
- une étape (28) de mesure du courant traversant la batterie (2) ;
- une étape d'intégration (30) du courant traversant la batterie (2) depuis le dernier recalage de l'état de charge de la batterie (2) ;
- une étape de calcul (32) d'un état de charge ($SOC_1$) de la batterie (2) à la température mesurée à partir de l'intégration du courant ;
- une étape de mesure (28) de la tension de repos après un temps (t) de la batterie (2) à la température mesurée et à l'état de charge calculé ;
- une étape de calcul (34) d'un état de charge réel ($SOC_2$) à partir de la tension de repos après un temps (t) mesurée et de la courbe (22) représentant la tension de repos après un temps (t) de la batterie avant sa mise en service en fonction de son état de charge à la température mesurée ; et
- une étape de comparaison (36) de cet état de charge réel ($SOC_2$) à l'état de charge calculé ($SOC_1$) pour déterminer la perte de capacité de la batterie (2).

**3.** Procédé selon la revendication 2, **caractérisé en ce que** la batterie (2) est une batterie électrochimique.

**4.** Procédé selon la revendication 3, **caractérisé en ce que** la batterie (2) est choisie parmi le groupe comportant des batteries de type Li-ion, NiMH, Ni-Zn, Plomb acide.

**Claims**

**1.** System to determine the loss in capacity of a battery (2) since the activation of the said battery (2), **characterized in that** it comprises:

- means (6) for measuring the temperature of the battery;
- means (10) for measuring the current passing through the battery (2);
- integration means (12) of the current passing through the battery (2) from the last resetting of the state of charge of the battery (2);
- calculating means (14) of a state of charge ($SOC_1$) of the battery (2) at the temperature measured from the integration of the current;
- storage means (16) of curves (22) representing the rest-state voltage after a time (t) of the battery (2) before its activation as a function of its state of charge at different temperatures;
- means (8) for measuring the rest-state voltage after a time (t) of the battery at the temperature measured and at the calculated state of charge ($SOC_1$) ;
- calculating means (18) of a real state of charge ($SOC_2$) from the rest-state voltage after a time (t) measured and of the curve (22) representing the rest-state voltage after a time (t) of the battery (2) before its activation as a function of its state of charge at the measured temperature; and
- comparison means (20) of this real state of charge ($SOC_2$) with the calculated state of charge ($SOC_1$) to determine the loss of capacity of the battery.

**2.** Method to determine the loss of capacity of a battery (2) since the activation of the said battery (2), **characterized in that** it comprises:

- a prior stage (26) for storage of curves (22) representing the rest-state voltage after a time (t) of the battery (2) before its activation as a function of its state of charge at different temperatures;
- a measuring stage (28) of the temperature of the battery (2);
- a measuring stage (28) of the current passing through the battery (2);
- an integration stage (30) of the current passing through the battery (2) since the last resetting of the state of charge of the battery (2);
- a calculation stage (32) of a state of charge ($SOC_1$) of the battery (2) at the temperature measured from the integration of the current;
- a measuring stage (28) of the rest-state voltage after a time (t) of the battery (2) at the temperature measured and at the calculated state of charge;
- a calculation stage (34) of a real state of charge ($SOC_2$) from the rest-state voltage after a time (t) measured and of the curve (22) representing the rest state voltage after a time (t) of the battery before its activation as a function of its state of charge at the temperature measured; and
- a comparison stage (36) of this real state of charge ($SOC_2$) with the calculated state of charge ($SOC_1$) to determine the loss of capacity of the battery (2).

3. Method according to Claim 2, **characterized in that** the battery (2) is an electrochemical battery.

4. Method according to Claim 3, **characterized in that** the battery (2) is selected from the group comprising batteries of the Li-ion, NiMH, Ni-Zn, lead-acid type.

**Patentansprüche**

1. System zum Bestimmen des Kapazitätsschwunds eines Akkus (2) seit der Inbetriebnahme des Akkus (2), **dadurch gekennzeichnet, dass** es Folgendes aufweist:

    - Mittel (6) zum Messen der Temperatur des Akkus;
    - Mittel (10) zum Messen des Stroms, der den Akku (2) durchquert;
    - Mittel zum Integrieren (12) des Stroms, der den Akku durchquert (2), seit dem letzten Einstellen des Ladezustands des Akkus (2);
    - Mittel zum Berechnen (14) eines Ladezustands ($SOC_1$) des Akkus (2), bei der ausgehend von der Integration des Stroms gemessenen Temperatur;
    - Mittel zum Speichern (16) von Kurven (22), die die Ruhespannung nach einer Zeit (t) des Akkus (2) vor seiner Inbetriebnahme in Abhängigkeit von seinem Ladezustand bei verschiedenen Temperaturen darstellen;
    - Mittel zum Messen (8) der Ruhespannung nach einer Zeit (t) des Akkus bei der gemessenen Temperatur und dem berechneten Ladezustand ($SOC_1$);
    - Mittel zum Berechnen (18) eines realen Ladezustands ($SOC_2$) ausgehend von der Ruhespannung nach einer gemessenen Zeit (t),

und der Kurve (22), die die Ruhespannung nach einer Zeit (t) des Akkus (2) vor seiner Inbetriebnahme in Abhängigkeit von seinem Ladezustand bei der gemessenen Temperatur darstellt; und
- Mittel zum Vergleichen (20) dieses realen Ladezustands ($SOC_2$) mit dem berechneten Ladezustand ($SOC_1$), um den Kapazitätsschwund des Akkus zu bestimmen.

2. Verfahren zum Bestimmen des Kapazitätsschwunds eines Akkus (2) seit der Inbetriebnahme des Akkus (2), **dadurch gekennzeichnet, dass** es Folgendes aufweist:

    - einen vorausgehenden Schritt des Speicherns (26) von Kurven (22), die die Ruhespannung nach einer Zeit (t) des Akkus (2) vor seiner Inbetriebnahme in Abhängigkeit von seinem Ladezustand bei unterschiedlichen Temperaturen darstellen;
    - einen Schritt des Messens (28) der Temperatur des Akkus (2);
    - einen Schritt des Messens (28) des Stroms, der den Akku (2) durchquert;
    - einen Schritt des Integrierens (30) des Stroms, der den Akku (2) seit der letzten Einstellung des Ladezustands des Akkus (2) durchquert;
    - einen Schritt des Berechnens (32) eines Ladezustands ($SOC_1$) des Akkus (2) bei der ausgehend von der Integration des Stroms gemessenen Temperatur;
    - einen Schritt des Messens (28) der Ruhespannung nach einer Zeit (t) des Akkus (2) bei der gemessenen Temperatur und dem berechneten Ladezustand;
    - einen Schritt des Berechnens (34) eines realen Ladezustands ($SOC_2$) ausgehend von der Ruhespannung nach einer gemessenen Zeit (t) und der Kurve (22), die die Ruhespannung nach einer Zeit (t) des Akkus vor seiner Inbetriebnahme in Abhängigkeit von seinem Ladezustand bei der gemessenen Temperatur darstellt; und
    - einen Schritt des Vergleichens (36) dieses realen Ladezustands ($SOC_2$) mit dem berechneten Ladezustand ($SOC_1$), um den Kapazitätsschwund des Akkus (2) zu bestimmen.

3. Verfahren nach Anspruch 2, **dadurch gekennzeichnet, dass** der Akku (2) ein elektrochemischer Akku ist.

4. Verfahren nach Anspruch 3, **dadurch gekennzeichnet, dass** der Akku (2) aus der Gruppe ausgewählt wird, die Akkus des Typs Li-Ion, NiMH, Ni-Zn, Blei Säure aufweist.

FIG.1

FIG.3

FIG.2

EP 2 001 074 B1

**EP 2 001 074 B1**

## RÉFÉRENCES CITÉES DANS LA DESCRIPTION

**Documents brevets cités dans la description**

- EP 1707974 A